# EUROPEAN PATENT APPLICATION

(11) **EP 4 819 138 A1**
(43) Date of publication of application: **07.10.2026**
(21) Application number: 25167882.7
(22) Date of filing: 02.04.2025
(51) Int. Cl.: G11C 11/16, G11C 11/56, G11C 19/08, G11C 11/18

(54) **A 3D VERTICAL MAGNETIC MEMORY DEVICE AND A METHOD FOR OPERATING THE MEMORY DEVICE**

(71) Applicant: Vertical Compute SRL, 1348 Ottignies-Louvain-la-Neuve (BE)
(72) Inventor: Couet, Sebastien, 1390 Grez-Doiceau (BE); Baig, Mohammed Aftab, 3010 Leuven (BE); Garcia Redondo, Fernando, Cambridge, CB43NG (GB)
(74) Representative: Roth, Sebastian

(57) **Abstract**

The disclosure relates to memory devices, and presents a 3D magnetic memory device. It comprises one or more memory pillars, each with a magnetic channel and memory cells for storing a plurality of magnetic bits along the magnetic channel. It further comprises a write track for generating a new magnetic bit in at least one memory pillar. It also comprises a push electrode for pushing the magnetic bits stored in the magnetic channel of the memory pillar along the magnetic channel. It further comprises a read electrode for reading a magnetic bit from the memory pillar. A controller controls the write track, push electrode, and read electrode to perform, selectively, each of the following: serial storing of data bits into one or more memory pillars; serial reading of data bits from one or more memory pillars; parallel storing of data bits into one or more memory pillars; parallel reading of data bits from one or more memory pillars.

## Description

### TECHNICAL FIELD

The present disclosure relates to magnetic memory devices. The disclosure presents a three-dimensional (3D) magnetic memory device that may achieve high memory density (bit density). The 3D magnetic memory device is configured to store data in and read data from one or more memory pillars. The disclosure also proposes a method for operating the 3D magnetic memory device.

### BACKGROUND

In the field of computing devices, a very large variety of memory architectures have been developed over the last decades depending on various technical constraints, for instance, depending on speed requirements, memory requirements, density requirements, and application type. For example, the static random-access memory (SRAM) architecture has been exploited for its high operating speed, but with a drawback related to its areal density. By contrast, the dynamic random-access memory (DRAM) architecture allows for a higher capacity working memory, but at lower speed. Moreover, (3D) NAND provides cheap high capacity, but is extremely slow compared to the other memory types. More recent advances introduced the spin-transfer torque (STT) magnetic random-access memory (STT-MRAM) architecture, which is a nonvolatile resistive memory exploiting a magnetic tunnel junction (MTJ).

However, there is need for new kinds of magnetic memory devices, in particular, devices which exploit all three spatial dimensions. The design of such magnetic memory devices departs from the planar array configuration, e.g. of conventional MRAM, and aims to move to 3D arrays instead. The 3D arrays may significantly increase the achievable memory density, to enable the storing of more information in the magnetic memory device.

### SUMMARY

The present disclosure is further based on the following.

A new technology for magnetic memory devices recently emerged, which is referred to as 3D vertical magnetic (3DVMAG) technology in this disclosure, and uses memory pillars (vertically arranged in the device) comprising magnetic channels to store magnetic bits along the magnetic channels. The 3DVAMG technology provides a sequential read/write structure, in which the magnetic bits are stacked in the form of oriented magnetic domains inside the magnetic channels.

The 3DVMAG technology can provide magnetic memory devices that achieve high operational speeds, high endurance, and a high storage density. Moreover, these devices may be built and adapted to any CMOS technology and applications. The magnetic memory devices may include features of spin-orbit torque magnetic random access memory (SOT-MRAM) and/or spin-transfer torque magnetic random-access memory (STT-MRAM) architectures. The magnetic memory devices use write currents to generate new magnetic bits, e.g. by SOT, use push currents to push magnetic bits into and along the magnetic channels, e.g. by STT, and use read electrodes, like MTJs, to read magnetic bits stored in the magnetic channels.

While this 3DVMAG technology is very promising, several challenges still need to be addressed, in order to mature it for a broad range of applications. For example, in order to exploit such magnetic memory devices for computing applications, an objective of this disclosure is to provide a solution for an efficient and flexible data organization in an array of the magnetic memory device. Thereby, as another objective, the footprint of the magnetic memory device should be kept as small as possible. In addition, the magnetic memory device should also enable different types of data access.

Moreover, an objective of this disclosure is to provide the magnetic memory device with a design comprising efficient circuitry for implementing write, and read, and push operations. The magnetic memory device should also be able to support high performance processing operations, computing operations that use artificial intelligence models like neural networks, and should be able to work with systolic arrays.

These and other objectives are achieved by the solutions of this disclosure, which are described in the independent claims. Advantageous implementations are described in the dependent claims.

A first aspect of this disclosure provides a 3D magnetic memory device comprising:
one or more memory pillars, wherein each memory pillar comprises a magnetic channel and a plurality of memory cells, for storing a plurality of magnetic bits, arranged along the magnetic channel; one or more write tracks, wherein each write track is associated with at least one of the memory pillars, and is controllable to generate a new magnetic bit in each memory pillar associated with said write track; one or more push electrodes, wherein each push electrode is associated with one of the memory pillars, and is controllable to push the magnetic bits stored in the magnetic channel of said memory pillar along the magnetic channel; one or more read electrodes, wherein each read electrode is associated with one of the memory pillars, and is controllable to read a magnetic bit from said memory pillar; a controller for controlling a storing of data bits of a data flow as magnetic bits in the one or more memory pillars, and for controlling a reading of magnetic bits from the one or more memory pillars as data bits of the data flow; wherein the controller is configured to control the one or more write tracks, push electrodes, and read electrodes to perform one of, or more of, or selectively each of the following: serial storing of data bits into the one or more memory pillars; serial reading of data bits from the one or more memory pillars; parallel storing of data bits into the one or more memory pillars; parallel reading of data bits from the one or more memory pillars.

The memory pillar may be the magnetic channel, or may comprise a stack in which the magnetic channel is formed. The stack may, for example, comprise a dielectric material, or may comprises multiple alternatingly stacked layers of, for example, dielectric material and silicon-based material, respectively. The magnetic channel may comprise a ferromagnetic material. The plurality of memory cells of the magnetic channel may, for instance, be realized by magnetic domain pinning sites created in the magnetic channel. This will be explained later in this disclosure in more detail. Each memory cell may be able to store one magnetic bit. The magnetic channel may be configured to store a plurality of magnetic bits along its length. Thus, the magnetic channel may store a bit sequence.

The magnetic memory device may comprise multiple of the memory pillars and magnetic channels, respectively, in order to implement a memory array of the magnetic memory device. The multiple memory pillars and magnetic channels may thereby be arranged in parallel to each other and/or may be arranged in an array comprising a plurality of rows and columns. That is, the memory pillars may be arranged in a 2D array, and may individually extend along the third dimension (typically referred to as vertical direction). Thus, the 3D magnetic memory device of the first aspect can exploit all three dimensions, and can depart from conventional planar configurations. Consequently, the magnetic memory device of the first aspect may have a significantly increased memory density, and can store more information than a conventional, planar magnetic memory device.

In an implementation of the magnetic memory device, the controller is configured to cause consecutive data bits of the data flow to be stored along a magnetic channel of a memory pillar.

This implementation enables memory operations with pseudo-random-access, so that data can be accessed controllably and repeatability.

In an implementation of the magnetic memory device, the controller is configured to cause consecutive data bits of the data flow to be stored in multiple memory pillars arranged in a same row of a memory pillar array.

In an implementation of the magnetic memory device, the controller is configured to store the data bits row-by-row into multiple rows of the memory pillar array.

These implementations enable row-level parallelism (similar to DRAM) where a row can be successively accessed many times to handle data with minimum latency.

In an implementation of the magnetic memory device, the controller is configured to access any row of the memory pillar array multiple times with only a single pre-charge of a wordline connected to the memory pillars of said row.

Thus, it is not needed to close a row and then activate and pre-charge another one, which would take additional time. Hence, this implementation may help processing data faster in some applications.

In an implementation of the magnetic memory device, the controller is configured to cause consecutive data bits of the data flow to be stored distributed over multiple memory pillars arranged in a tile, wherein the tile comprises two or more rows and/or two or more columns of a memory pillar array.

In an implementation of the magnetic memory device, the controller is configured to cause the data bits of the data flow to be stored spread out across all of the memory pillars of said tile.

These implementations enable sequential access to deeper data, and allow parallelism.

Notably, a tile may be a sub-array of a memory pillar array of the magnetic memory device. A tile may be a set of memory pillars arranged in a pattern, such as a grid-like structure with rows and columns. A tile may have read electrodes, selectors, and connections, and other related components that are grouped together. The magnetic channels in a tile may share connections, e.g. a common write track, and/or common write lines, and/or common read lines, allowing each of the memory pillars to be accessed efficiently to store or retrieve data. The form of a tile may depend on the memory components that compose it. Various configuration having varying number, dimensions, and positions of connections, selectors, read electrodes, magnetic channels, etc., are possible. Those characteristics impacts the compactness and arrangement of the components and shared connections and therefore they impact how the tile looks like but also its performance overall.

In an example, the magnetic memory device comprises multiple memory pillars placed along a set rows and/or a set of columns, so as to form a working block of memory referred to as a tile. Current lines may be shared between magnetic channels from the same row or from the same column. For example, the write line of a row of memory pillars may be shared and controlled by the same write selector. Similarly, the read line of a column of memory pillars may be shared and controlled by the same read selector.

In an implementation of the magnetic memory device, the data bits of the data flow are respectively stored in and read from the one or more memory pillars in either a first in first out, FIFO, manner, or in a first in last out, FILO, manner.

Managing the data as FIFO enables pipelining, which may improve efficiency and throughput by overlapping the execution of multiple operations, e.g. writing and reading in parallel. On the other hand, FILO is beneficial for stack-based applications, like function calls, undo operations, and memory allocation tasks.

In an implementation of the magnetic memory device, the magnetic memory device further comprises a first support circuit for supporting a write operation, and/or a push operation, and/or a read operation of data bits of the data flow controlled by the controller.

In an implementation of the magnetic memory device, the first support circuit comprises a plurality of bitlines for providing a push current for respectively pushing data bits of the data flow along the one or more memory pillars.

In an implementation of the magnetic memory device, the controller is configured to control a plurality of write enable switches, and a plurality of read enable switches, and a plurality of push enable switches of the first support circuit, to perform a write operation, and/or push operation, and/or read operation on the data bits of the data flow.

In an implementation of the magnetic memory device, the magnetic memory device further comprises a second support circuit for supporting a rewrite operation of data bits of the data flow, which have been read from the one or more memory pillars, controlled by the controller.

The rewrite may prevent data loss that could be caused by a destructive read from one or more memory pillars.

In an implementation of the magnetic memory device, the second support circuit comprises a buffer configured to store data bits extracted during a read operation from the one or more memory pillars, and the controller is configured to rewrite the data bits stored in the buffer into the one or more memory pillars.

In an implementation of the magnetic memory device, the controller is configured to control a multiplexer of the second support circuit to selectively perform a write operation to write or a rewrite operation to rewrite data bits into the one or more memory pillars.

In an implementation of the magnetic memory device, the magnetic memory device further comprises a third support circuit comprising a processor for performing processing operations on data bits of the data flow before storing the data bits into the one or more memory pillars and/or after reading the data bits from the one or more memory pillars.

In an implementation of the magnetic memory device, the data flow comprises input data, and/or weights, and/or output data of a trained model, for example, a neural network.

In an implementation of the magnetic memory device, the third support circuit comprises a feedback loop for feeding back results of the processing operations performed on the data bits to the processor.

In an implementation of the magnetic memory device, the third support circuit further comprises one or more buffers for temporarily buffering data bits of the data flow used for the processing operations; and the controller is configured to control the one or more buffers to provide buffered data bits to the processor or buffer data bits received from the processor.

In an implementation of the magnetic memory device, the third support circuit further comprises one or more accumulators for collecting intermediate processing results of the processing operations performed by the processor; and the controller is configured to control the one or more accumulators to provide buffered intermediate processing results to the processor or accumulate intermediate processing results received from the processor.

In an implementation of the magnetic memory device, the magnetic memory device comprises: a stack of alternatingly arranged silicon-based and dielectric layers, wherein the one or more magnetic channels of the one or more memory pillars respectively extend through the layers of the stack; wherein a plurality of pinning sites is defined by the layers of the stack and formed in each respective magnetic channel, and each pinning site is configured to store at least one magnetic bit; a first metallic layer arranged on a first end of the stack and the respective magnetic channel; one or more MTJs arranged, as the one or more read electrodes, on the first metallic layer; a first push electrode arranged on the first metallic layer in a distance to the MTJ; wherein either the first metallic layer is a write track configured as a spin-orbit-torque, SOT, track, or wherein second metallic layer is arranged, as the write track and configured as a SOT track, on a second end of respectively the magnetic channel and the stack.

In an implementation of the magnetic memory device, the magnetic memory device further comprises a second push electrode arranged on or below the second end of the magnetic channel.

A second aspect of this disclosure provides a method for operating a 3D magnetic memory device according to the first aspect and its implementations, wherein the method is performed by the controller of the magnetic memory device and comprises at least one of the following: serial storing of data bits into the one or more memory pillars, and serial reading of data bits from the one or more memory pillars; parallel storing of data bits into the one or more memory pillars, and parallel reading of data bits from the one or more memory pillars.

The method of the second aspect may have implementations that correspond to the implementations of the magnetic memory device of the first aspect. The method of the second aspect and its implementations achieve the effects and advantages described above with respect to the magnetic memory device of the first aspect and its corresponding implementations.

In an implementation of the method, the serial or parallel storing of the data bits comprises storing of input data, and/or of weights, and/or of output data, of a trained model, for example, of a neural network.

In an implementation of the method, the method comprises performing one or more processing operations on the data bits before storing the data bits into the one or more memory pillars and/or after reading the data bits from the one or more memory pillars; and optionally feeding back results of the one or more processing operations performed on the data bits for performing one or more further processing operations.

In an implementation of the method, the method further comprises temporarily buffering data bits used for the one or more processing operations; and/or providing buffered data bits for performing further processing operations.

In an implementation of the method, the method comprises collecting intermediate processing results of the one or more processing operations; and/or providing buffered intermediate processing results for performing one or more further processing operations.

A third aspect of this disclosure provides a computer program comprising instructions, which, when the computer program is executed of a controller of a magnetic memory device, causes the controller to perform the method according to the second aspect.

In summary of the above aspects and implementations, the memory architecture proposed in this disclosure is a sequential read/write structure, in which magnetic bits are (vertically) stacked, for example, in the form of oriented magnetic domains, inside a magnetic channel. The magnetic channel may be made of a ferromagnetic or ferrimagnetic and/or conductive material (e.g., cobalt, nickel, iron, alloys thereof, or any of the former with the addition of boron).

Domain pinning for high retention may be achieved by embedding the magnetic channel in a stack of the dielectric and silicon-based layers, which are alternately arranged one on top of the other along a stacking direction. The morphology of the stack can be tuned to enhance or reduce pinning. For example, the height ratio between the two types of layers may be varied, and/or different magnetic channel diameters may be formed in each type of layer. The magnetic memory device of this disclosure may combine features of previous technologies like SOT-MRAM or 3D-NAND.

To properly exploit the potential of the 3D magnetic memory device, this disclosure provides a detailed description of the memory pillars, memory pillar arrays and its various configurations, and support circuits that are designed to perform reading, pushing, and writing operations on data within a memory pillar and an array made of such memory pillars, respectively. The various components and connections are made as compact as possible to achieve the highest density. This allows the creation of a new generation of 3D data storage system.

Notably, in this disclosure, individual implementations can be combined with each other, as long as they do not exclude each other.

### BRIEF DESCRIPTION OF THE DRAWINGS

The above described aspects and implementations are explained in the following description of embodiments with respect to the enclosed drawings:
- FIG. 1: shows a magnetic memory device according to this disclosure, with a magnetic channel in a memory pillar.
- FIG. 2: shows an exemplary magnetic memory device according to this disclosure, with a magnetic channel in a stack of alternating layers.
- FIG. 3: illustrates a configuration, in which data bits are stored along the magnetic channels of memory pillars.
- FIG. 4: illustrates a configuration, in which data bits are stored across the magnetic channels of memory pillars.
- FIG. 5: illustrates a configuration, in which data bits are stored across tiles of memory pillars.
- FIG. 6: illustrates how data is managed to be written and read in a magnetic channel, wherein the data can be stored along the magnetic channel (a) according to FIFO and (b) according to FILO.
- FIG. 7: shows how data is managed to be written and read in magnetic channels, wherein the data can be stored across the magnetic channels in a configuration (a) according to FIFO and (b) according to FILO.
- FIG. 8: illustrates a write operation and a push operation into a magnetic channel of a memory pillar of a magnetic memory device according to this disclosure.
- FIG. 9: shows a support circuit of a memory array of a magnetic memory device according to this disclosure.
- FIG. 10: illustrates details of the support circuit used for a push operation.
- FIG. 11: shows a support circuit for a rewrite operation, the support circuit comprising a multiplexer.
- FIG. 12: shows a sequence of excitation signal to operate the rewrite support circuit.
- FIG. 13: shows a magnetic memory device according to this disclosure, which is used to store computation's operands of a processing element.
- FIG. 14: shows a magnetic memory device according to this disclosure, which is suitable for computations with an SRAM buffer holding input data and a memory pillar array holding unrolled weights.
- FGI. 15: shows a method of operating a magnetic memory device according to this disclosure.

Same elements in the figures are labelled with the same reference signs, and may be implemented likewise, even if not redundantly described.

### DETAILED DESCRIPTION OF EMBODIMENTS

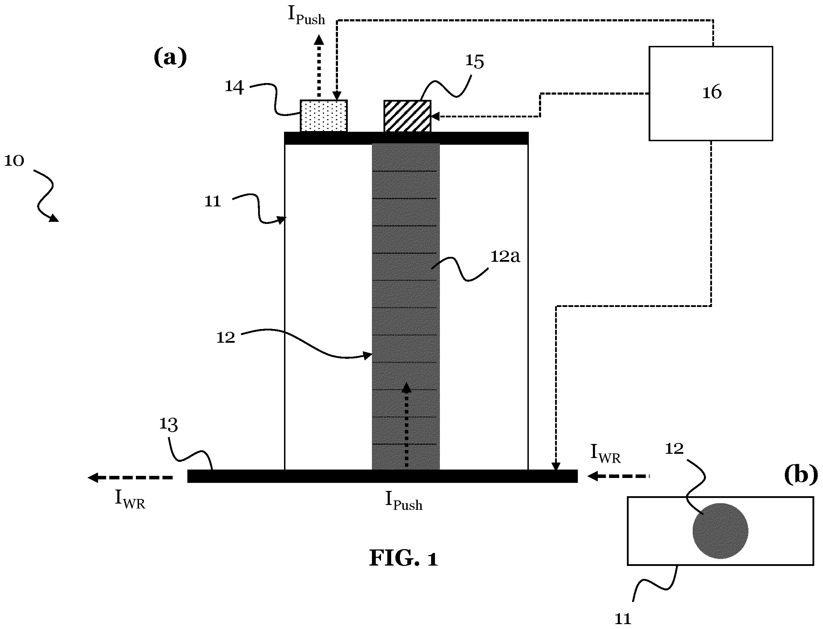

FIG. 1 shows a 3D magnetic memory device 10 according to this disclosure. In particular, a cross-sectional side view is shown in FIG. 1(a), and cross-sectional top view is shown in FIG. 1(b).

The magnetic memory device 10 comprises one or more memory pillars 11. Only a single memory pillar 11 is shown in FIG. 1, however, as an example and for ease of illustration. Each memory pillar 11 - like the one shown - comprises a magnetic channel 12 and a plurality of memory cells 12a. The plurality of memory cells 12a is suitable for storing a plurality of magnetic bits, for instance, one magnetic bit per memory cell 12a. The memory cells 12a are arranged along the magnetic channel 12, which is arrange vertically in FIG. 1 and in the final magnetic memory device 10. Accordingly, the memory cells 12a are vertically stacked, and the memory pillar 11 may be referred to as vertical memory pillar.

The magnetic memory device 10 also comprises one or more write tracks 13, wherein each write track 13 is associated with at least one of the memory pillars 11. In FIG. 1 only one write track 13 associated with the shown memory pillar 11 is illustrated as an example. However, in an array of memory pillars 11 of the magnetic memory device 10, there may be more write tracks 13 and/or multiple memory pillars 11 may be associated with the same write track 13. Each write track 13 can be controlled to generate a new magnetic bit in each memory pillar 11 that is associated with said write track 13. This controlling of the write track 13 may comprise sending a write current along the write track 13. This may implement a write operation, and may be controlled by a controller 16.

The magnetic memory device 10 also comprises one or more push electrodes 14, wherein each push electrode 14 is associated with one of the memory pillars 11. In FIG. 1 only one push electrode 14, namely the one associated with the shown memory pillar 11, is illustrated as example. Each push electrode 14 can be controlled to push the magnetic bits stored in the magnetic channel 12 of said memory pillar 11 along the magnetic channel 12. This controlling of the push electrode 14 may comprise sending a push current through the push electrode 14 into the magnetic channel 12. This may implement a push operation, and may be controlled by the controller 16.

The magnetic memory device 10 also comprises one or more read electrodes 15, wherein each read electrode 15 is associated with one of the memory pillars 11. In FIG. 1 only one read electrode 15, namely the one associated with the shown memory pillar 11, is illustrated as example. Each read electrode 15 can be controlled to read a magnetic bit from the memory pillar 11. This controlling of the read electrode 15 may comprise passing a read current through the read electrode 15. This may implement a read operation, and may be controlled by the controller 16.

The magnetic memory device 10 further comprises the controller 16 for controlling the storing of data bits of a data flow as magnetic bits in the one or more memory pillars 11, and for controlling the reading of magnetic bits from the one or more memory pillars 11 as data bits of the data flow. The controller 16 is configured to control the one or more write tracks 13, push electrodes 14, and read electrodes 15 - e.g. to apply the respective currents mentioned above - to implement the write, read, and push operations. The controller 16 is particularly configured to perform one of, or more of, or selectively each of the following: serial storing of data bits into the one or more memory pillars 11; serial reading of data bits from the one or more memory pillars 11; parallel storing of data bits into the one or more memory pillars 11; and parallel reading of data bits from the one or more memory pillars 11.

Parallel storing may thereby comprise storing in parallel in multiple memory pillars 11, likewise the parallel reading. Selectively performing each of the listed operations may mean that the controller 16 is able to implement each one of the listed operations, but selectively only one of these operations at a same time, at least if the same memory pillar(s) 11 is/are concerned.

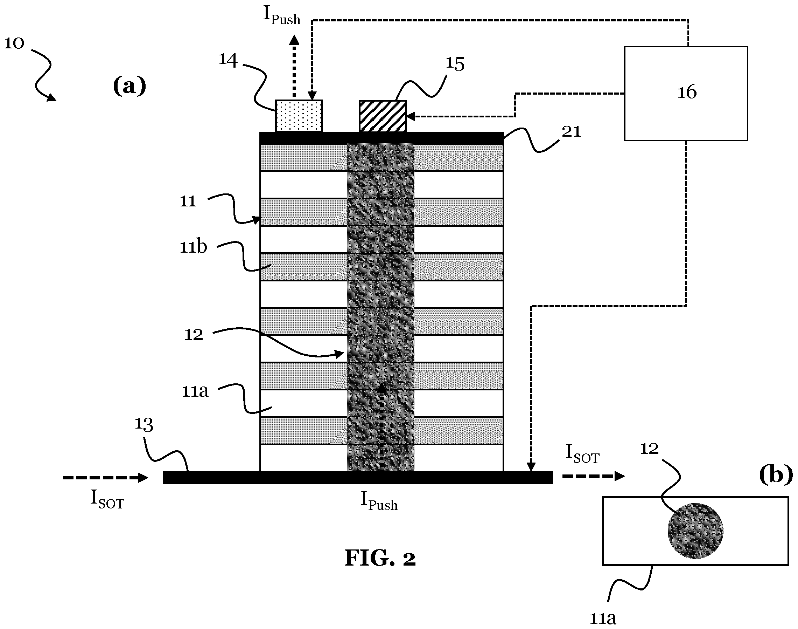

FIG. 2 shows a magnetic memory device 10 according to a specific example, which builds on the magnetic memory device 10 shown in FIG. 1. In particular, a cross-sectional side view is shown in FIG. 2(a), and cross-sectional top view is shown in FIG. 2(b).

The magnetic memory device 10 of FIG. 2 comprises a memory pillar 11 including a stack of alternatingly arranged dielectric layers 11a and silicon-based layers 11b. The magnetic channel 12 of the memory pillar 11 extends through these layers 11a, 11b of the stack. A plurality of pinning sites is defined by the layers 11a, 11b of the stack and is formed in the magnetic channel 12 extending through these layers 11a, 11b. Each pinning site is configured to store at least one magnetic bit, i.e., each pinning site may correspond to one of the memory cells 12a. Notably, there are other possibilities to generate the plurality of memory cells 12a in the magnetic channel 12, and the use of pinning sites is only an example.

The magnetic memory device 10 further comprises a first metallic layer 21 arranged on a first (upper) end of the stack 11 and the magnetic channel 12, respectively. One or more magnetic tunnel junctions (MTJs), as the one or more read electrodes 15, are arranged on the first metallic layer 21. One MTJ 15 is illustrated in FIG. 2, and is associated with the shown memory pillar 11. Further, the push electrode 14 is arranged on the first metallic layer 21 in a distance to the MTJ 15.

The magnetic memory device 10 of FIG. 2 may further comprise a second metallic layer, used as the write track 13, which may particularly be configured as spin-orbit-torque (SOT) track. The SOT write track 13 may be controlled, by the controller 16, by sending an SOT current along the SOT track 13, in order to generate a new magnetic bit in the magnetic channel 12 of the memory pillar 11. Additionally or alternatively, the first metallic layer 21 may also be configured as SOT write track. The first and the second metallic layer 13, 21 are notably arranged on opposite ends of the stack 11 and the magnetic channel 12.

The magnetic memory device 10 of FIG.2 may further comprises a second push electrode (not shown), which can be arranged on or below the second (lower) end of the magnetic channel 12, for instance, on the write track 13. The push current may pass through both push electrodes and the magnetic channel 12 in this case.

The pinning sites in the magnetic channel 12 may be generated by the alternating layers 11a, 11b and their interfaces. The pinning sites are locations where magnetic domains (or more specifically, the domain walls that separate these magnetic domains) are "pinned" or stabilized. Thus, each pinning site is configured to stabilize (and thus configured to store) a particular magnetic state in the magnetic channel 12, the state representing at least one (magnetic) bit of information. Domain walls may nucleate in the magnetic channel 12 like in any magnetic material, once it becomes energetically unfavorable to keep a single uniform domain, and may form multiple magnetic domains that expand to minimize the internal energy. The domain walls may be interfaces separating two magnetic domains and acting as a continuous transition across a finite distance between different magnetic moments, which may have an angular displacement of 90° or 180°. The stability of the magnetic domains may be ensured by the overall minimization of both the overall anisotropy energy (including magneto-crystalline and shape effects) and the exchange energy at the interfaces between the domains. Each new domain then has its own orientation, different from its neighbor domains. It could be antiparallel or even pointing toward a different direction depending on the configuration.

It is possible to have multiple magnetic domains in the magnetic channel 12, which are oriented along a given axis. This may be achieved by having a long magnetic channel 12, since that provides a high shape anisotropy that incites the magnetization to align along the channel's longitudinal axis. By exploiting geometric features (e.g., notches, sharp angles, discontinuities), the propagation of magnetic domains may be prevented beyond each domain wall. Deliberately fabricating the pinning sites, by at least using the alternating layers 11a, 11b of the stack, may shape the energy landscape and allow for the control of the position of the magnetic domain walls.

The magnetic memory device 10 of FIG. 2 can employ SOT for writing information into the magnetic channel 12, and can employ tunnel-magnetoresistance (TMR) using the MTJ as read electrode 15 to read out information from the magnetic channel 12. SOT is a phenomenon wherein an electrical current flowing through the SOT (write) track 13 gives rise to a change in magnetization direction in the magnetic channel 12. The SOT track may be a bi-layer consisting of a heavy metal layer and a magnetic layer. Specifically, a combined interaction between SOT and the Dzyaloshinskii-Moriya interaction (DMI) leads to the nucleation and stabilization of a magnetic domain with a given magnetic orientation and to an asymmetric domain wall motion, wherein the direction of movement of the domain wall depends on these two effects. The DMI is an exchange interaction, which is antisymmetric and arises due to spin-orbit coupling (SOC) in structures with broken inversion symmetry.

In practice, the SOT current (e.g., provided as a pulse through the write track 13 and/or the metallic layer 21) may orient the magnetization in the first few nanometers of the magnetic material of the magnetic channel 12, in-plane, i.e. pointing in the same direction as the electrical spin-polarized current. The spins further away from the interface are under the influence of the DMI. With respect to a Cartesian coordinate system chosen such that the X and Y axes align with the Dzyaloshinskii-Moriya vector and the current direction respectively, the energetic contribution can be written as follows: $\begin{matrix}{\hat{H}}^{DMI} & = \vec{{D}_{ιj}} ⋅ \left(\vec{{S}_{ι}}\times \vec{{S}_{j}}\right) \\ & = - {D}_{ij} {ê}_{x} ⋅ \left(\left[{{S}_{i}}^{y}{{S}_{j}}^{z}-{{S}_{i}}^{z}{{S}_{j}}^{y}\right] {ê}_{x}\right) \\ & = - {D}_{ij} \left[{{S}_{i}}^{y}{{S}_{j}}^{z}-{{S}_{i}}^{z}{{S}_{j}}^{y}\right] .\end{matrix}$

With the magnetization close to the interface being oriented along the current, in other words along the y-axis of said coordinate system, the spin there may be rewritten as *̅S̅ₗ̅*̅ = *Sᵢ^{ye}* ê*_{y}*. To provide a stable configuration, looking for the energetic minimum gives that *S̅_{J}* = *Sⱼ^{z}* ê*_{z}* so that *Ĥ^{DMI}* = *- Dᵢⱼ Sᵢ^{y}Sⱼ^{z}* with *Dᵢⱼ* > 0 indicating the efficiency of the interaction, and *Sᵢ^{y}* > 0, *Sⱼ^{z}* > 0. To put it another way, this interaction favors a configuration where the two spins have a 90° angle, leading to the spin located further away being oriented perpendicular to the interface between the SOT track 13, 16 and the vertical magnetic channel 12. This rule can therefore, from an initially in-plane magnet, lock a perpendicular depending on the direction of the SOT current. For example, an in-plane current pointing right leads to down magnetization, while one pointing left leads to up magnetization.

The magnetic memory device 10 of FIG. 2 can also employ spin-transfer-torque (STT) for writing information into the magnetic channel 12. STT is a phenomenon wherein the magnetization direction of a magnetic layer such as the magnetic channel 12 is modified by a spin-polarized current. Usually, current is 50% spin up and 50% spin down electrons, but polarization can be obtained, for example, by passing the current through a thick magnetic layer.

Information can be moved in the magnetic channel 12 by the push current, and thus moving magnetic bits stored in the magnetic channel 12 from one pinning site to the next. As mentioned, the pinning sites are enabled by the periodicity of the layers 11a, 11b of the stack, and are able to stabilize a magnetic domain, for instance, within a single layer height. Hence, the height of a magnetic bit can be defined by said periodicity. To overcome those pinning sites, a supplementary magnetic field or a spin-polarized current may be applied. Each domain wall provides an energy well that requires some threshold driving force to overcome the potential barrier. For example, for a spin-polarized current running through the magnetic channel, the interaction (in particular the s-d exchange coupling) between the spin angular momentum of the itinerant electrons and the magnetization of the material may lead to a possible displacement of the domain wall to the next pinning point through a domain pushing force based on STT, and thereby a change of magnetization in that portion of the wire.

The magnetic channel 12 may also be referred to as a magnetic wire in this disclosure, and may be part of the magnetic pillar 11, like the stack of alternating layers 11a, 11b if present. The magnetic channel 12 may constitute together with the write track 13 (e.g., SOT track), the read electrode 15 (e.g., MTJ) and one or more (push) electrodes a 3DVMAG element (or short "3DVMAG") of the magnetic memory device 10.

In the following, exemplary implementations of the magnetic memory device 10, in particular details concerning the operation and circuitry of the magnetic memory device 10, will be explained.

First, various implementations relating the data organization in the magnetic memory device 10 will be discussed.

Generally, memory devices that are used for storage and accessing of data structures may be employed in high-performance computing, wherein large data sets are processed using a first-in, first-out (FIFO) access, commonly referred to as queue-based applications. Conversely, stack-based applications, which require first-in, last-out (FILO) accessible memory systems are ideal for function calls, undo operations, and memory allocation tasks. Accordingly, the magnetic memory device 10 of this disclosure is beneficially provided with both options.

Further, off-chip memories, such as dynamic random access memory (DRAM), which transfer data to on-chip memories, such as caches or registers, necessitate parallel access to multiple bits equivalent to the processor's data width. The magnetic memory device 10 of this disclosure is thus enabled accordingly. Notably, the organization of these bits in the magnetic memory pillars 11 may affect the system performance.

As explained in the following, the magnetic memory device 10 - also referred to as a 3DVMAG memory - is dynamic and versatile, and is suitable for a wide range of applications, including data buffers for high-performance computing, and as a DRAM replacement for data transfer.

In particular, the controller 16 may be configured to control the flow of data in, from, and to an array of memory pillars 11 - wherein the memory pillars 11 may be arranged in rows and columns - such that the data can be arranged in various configurations within the array. Dynamic arrangement of data is very helpful in case the end application is largely unknown, such as providing data to an on-chip memory (like DRAM memory) or to be used as data buffer for high performance computing.

The controller 16 may be able to select how the data is to be written, stored, and retrieved from the array, or may receive according instructions. The controller 16 can be used alongside universal shift registers, and may be capable of handling operations such as shifting data, storing, loading data serially or in parallel, reading data serially or in parallel. At least three ways of organizing data within the magnetic memory device 10 may be distinguished: along the magnetic channels 12 of memory pillars 11, across the magnetic channels 12 of memory pillars 11, and across the magnetic channels 12 of tiles of memory pillars 11.

In particular, in a first configuration, the controller 16 is configured to cause consecutive data bits of a data flow to be stored along a magnetic channel 12 of a memory pillar 11. In this configuration, the bits of data can be written, stored, and read along each magnetic channel 12, in other words vertically in the magnetic memory device 10.

In a second configuration, the controller 16 is configured to store the data bits across memory pillars 11. In particular, row-by-row into multiple rows of the memory pillar array. For example, the controller 16 may be configured to cause consecutive data bits of the data flow to be stored distributed over multiple memory pillars 11, which are arranged in a block or tile. Such a tile may comprise two or more rows and/or two or more columns of a memory pillar array. In this configuration, bits of data can be written, stored, and read across the magnetic channels 12 of the memory pillars 11, for example, within a tile. For instance, the controller 16 is configured to cause the data bits of the data flow to be stored spread out across all of the memory pillars 11 of said tile.

In a third configuration, the controller 16 is configured to store, write, and read the bits of data across a set of tiles, with data being partitioned and spread across each of the tiles.

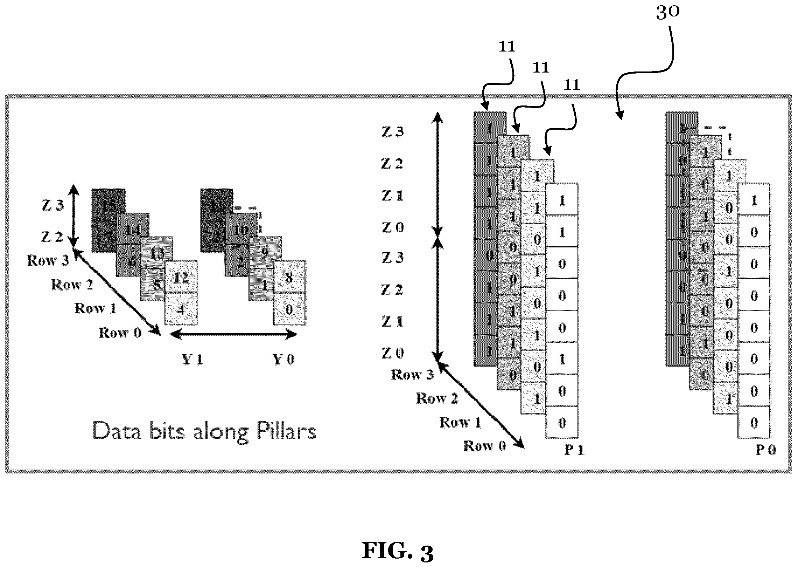

The first configuration is illustrated by FIG. 3. In the first configuration, bits of data can be written, stored, and read along the magnetic channels 12 of the memory pillars 11. FIG. 3 shows data stored in a memory pillar array 30 of the magnetic memory device 10 in its decimal representation with values ranging from 0 to 15 (on the left) and in binary representation (on the right). The "Row", "Y" and "Z" indices are coordinates indicating where the data is located along the rows (corresponding to X-axis) and columns (corresponding to Y-axis) of the array of vertical (i.e. extending along the Z-axis) memory pillars 11. The equivalent representation with the binary values shows more concretely how the magnetic bits can fill the vertical magnetic channels 12 (of the memory pillars 11) in this mode of operation to achieve this result.

This configuration enables memory operations with pseudo-random-access, provided that all the bits of data are kept in the same magnetic channel 12, so that data can be accessed controllably and repeatability. This also means that data in a magnetic channel 12 can only be accessed sequentially, which can limit its speed for writing and reading. Moreover, its read speed may be also be limited due to pre-charge operations before sensing the data.

Depending on how the magnetic memory device 10 is built, the data can be managed in the magnetic channel(s) 12 either as FIFO or as FILO. Information regarding the impact of each of these configurations is provided further below in this disclosure.

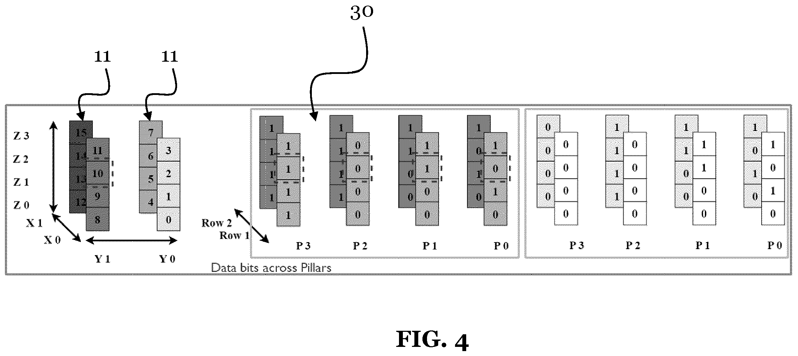

In the second configuration, the bits of data can be written, stored, and read across the magnetic channels 12 (e.g. within a tile) in one or the other horizontal direction. This is illustrated in FIG. 4, which shows data stored in the magnetic memory devices in its decimal representation with values ranging from 0 to (on the left) and in binary representation (on the right). Again, the data is shown stored in locations of the array 30 mapped with coordinates X, Y, Z regarding the likewise named axes. The equivalent representation with the binary values provides a more concrete visualization of how the data is arranged in the memory array as magnetic bits. A given piece of data can be spread horizontally over the vertical magnetic channels 12 at a given vertical coordinate (memory cell 12a on a certain vertical level).

This configuration involves sequential access to data nested deeper in the channel(s) 12, i.e. writing and reading data may follow an ordered, predetermined procedure starting from a specific point in memory and then proceeding step-by-step to the next item in sequence. Moreover, since data may be accessed in parallel and row-by-row, this enables row-level parallelism (similar to DRAM) where the data bits can be parallelly accessed within a single clock cycle with minimum latency. It is thereby no longer needed to close a row and then activate and pre-charge another one, which would normally take additional time. Hence, this configuration can help processing data faster in some applications.

In the same way as the previous configuration, the data can be managed in the magnetic memory device 10 either as FIFO or FILO.

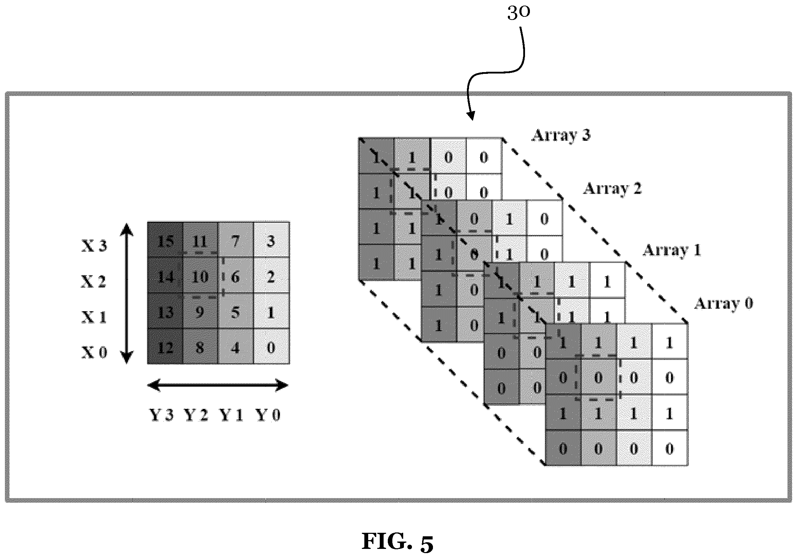

In the third configuration, bits of data can be written, stored and read across a set of different memory tiles, with data being partitioned (e.g., bit by bit) and spread across each of the structures. This is illustrated in FIG. 5, which illustrates the data again in its decimal representation with values ranging from 0 to 15 (on the left) and in binary representation (on the right). The data is stored in locations mapped to the coordinates X, Y corresponding to the likewise named axes. In this configuration a given piece of data is partitioned over different memory tiles. Similar to the previous configuration, this mode has sequential access to deeper data and allow parallelism.

Next, various implementations relating the data access type in the magnetic memory device 10 will be discussed.

Data access type largely depends on the design of the magnetic memory device 10, but, for example, a magnetic memory device 10 with two write tracks 13 (e.g. two SOT tracks implemented by the first and second metallic layers 13, 21 shown in FIG. 2) and dual read electrodes 15 (e.g. MTJs, one on the first metallic layer 21 at one end of the magnetic channel 12, the other one on the second metallic layer 13 at the other end of the magnetic channel 12) can be configured to be used as FILO and FIFO using the controller 16 to support stack and queue applications. In other words, the data bits of the data flow can respectively be stored in and read from the one or more memory pillars 12 in either a FIFO manner or in a FILO manner.

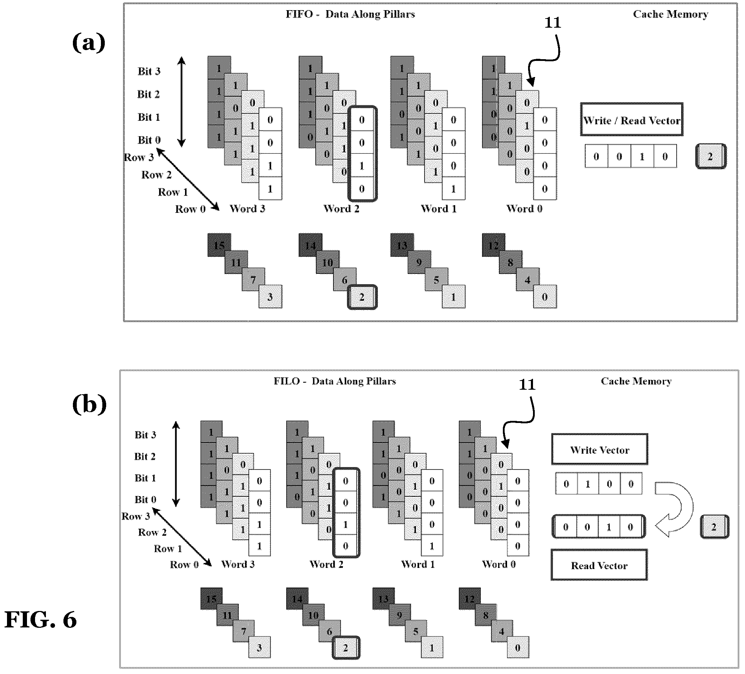

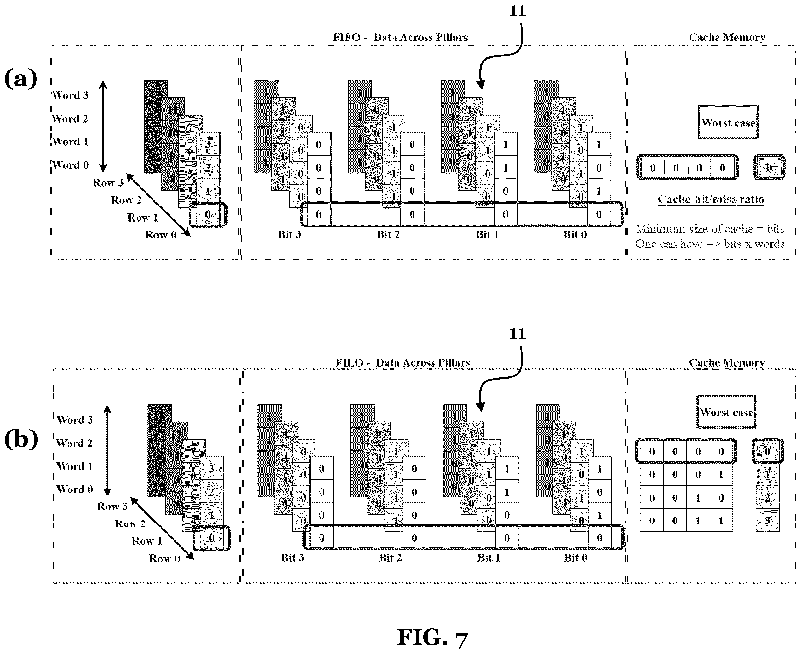

Data managed as FIFO can be used in the same form when writing and reading it (see, for instance, FIG. 6a and FIG. 7a). This enables pipelining, i.e., a method improving efficiency and throughput of data management by overlapping the execution of multiple operations, e.g. writing and reading in parallel. Since the data is in a consistent form, operations on it can occur in a predictable and synchronized manner, allowing instructions in the pipeline to progress smoothly, without the need for significant delays or extra complexity to ensure that the correct data is accessed.

By contrast, data arranged vertically and managed as FILO (see, for example, FIG. 6(b) and FIG. 7(b)) requires a bit reversal operation, since the read vector appears in the inverse order compared to the write vector. This may require additional register space and can increase the complexity of the implementation since predictions become difficult. Moreover, pipelining can be inefficient if the mismatching order causes instructions to stall or wait for data to be correctly aligned, breaking thereby the smooth progression in the pipeline. Furthermore, the pipeline may require additional time to introduce extra control mechanisms ensuring that the correct data is read at the right time.

Additionally, accessing a location in memory to write or read data does preferably not affect other locations of the memory, e.g. causing loss or corruption of data. This is especially important when using a cache (or buffer) memory that fetches data at a specific location and may need to update it and write it back at the same location. Accordingly, the magnetic memory device 10 may comprise a cache or buffer. The cache or buffer size can be optimized to save physical space, or to optimize the hit-to-miss ratio, which relates to the probability that when the data is requested, it is already present in the cache and can therefore be retrieved faster than if it only existed in the main memory.

In any case, the minimal size for the cache memory depends on whether the memory can be normally operated without issue in the worst-case scenario, i.e. when the data to access is located the furthest away from the reading components. To operate with a FIFO implementation, the cache memory needs to have the capacity to store one bit per vertical magnetic channel accessed. By contrast, a FILO implementation would require to store all the content of the accessed channels to prevent loss of data.

To summarize, the following tables are provided. Table 1 shows characteristics of the data organization, and Table 2 shows characteristics of the channel type.

**Table 1**

| **Data organization** | **Accessing the bits of a word** |
|---|---|
| Word stored along a channel | Sequential |
| Word stored across channels | Parallel |
| Word stored across tiles | Parallel |

**Table 2**

| **Channel type** | **Minimal cache/ buffer size** | **Pipelining** |
|---|---|---|
| FILO | Whole channel(s) | No |
| FIFO | 1 bit for each channel | Yes |

Next, implementations relating support circuitry for push operations will be discussed. Generally, the magnetic memory device 10 can comprise a support circuit for supporting a write operation, and/or a push operation, and/or a read operation of data bits of the data flow controlled by the controller 16. The support circuit may be in a periphery of a memory array 30, which is formed by multiple memory pillars 11 of the magnetic memory device 10.

The periphery circuitry in a memory array typically aids in carrying out memory read and write operations, and typically comprise of decoders, multiplexers, switches, read/write circuits, drivers and sense amplifiers. In the present disclosure, the periphery circuitry may comprise the support circuit built to be able to handle the push operations.

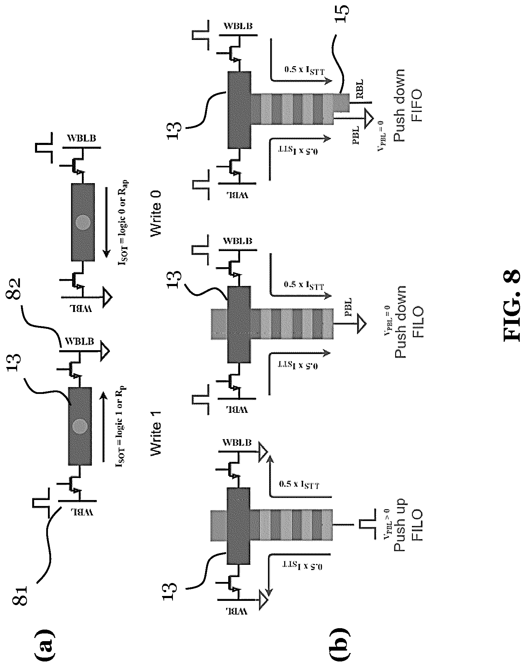

Before pushing the magnetic bits (e.g. magnetic domains) in a magnetic channel 12, a magnetic bit is created using a write operation, for instance, by SOT nucleation as explained above. For a simple explanation, a magnetic memory device 10 with a single memory pillar 11 is considered, which may have an SOT track as the write track 13, and which may have an MTJ as the read electrode 15. FIG. 8 shows nucleating a parallel state (Rp) or logic 1, and an antiparallel state (Rap) or logic 0, with reference to the direction of the current along the SOT track.

In an exemplary configuration of the memory pillar 11, the write track 13 (e.g. SOT track) and the read electrode 15 (e.g. MTJ) are on the same side of the magnetic channel 12. This configuration is typically known as a FILO system, in which the nucleated domains are pushed up and down the memory pillar 11 stack, which may be implemented by a bidirectional current flow along the memory pillar 11. On the other hand, in a configuration for a FIFO system, the write track 13 and the read electrode 15 may be arranged on opposite sides (opposite ends) of the magnetic channel 12, so that only a push down operation may be used. Possible write and push excitation signals for carrying out various write and push operations are summarized in Table 3 below, and are shown FIG. 8.

In particular, FIG. 8 shows representations of write and push operations of the magnetic memory device 10. FIG. 8(a) shows a current passing from a write bitline 81 (WBL) over the write track 13 to a complementary write bitline 82 (WBLB), which leads to the nucleation of a parallel state or logic 1 in the first memory cell 12a of the magnetic channel 12, while a current passing in the reverse direction leads to the nucleation of an antiparallel state or logic 0. FIG. 8(b) shows three pushing configurations, whereof two are of a FILO system where domains are pushed up or are pushed down, respectively, and one is of a FIFO system where domains only are pushed down. In case of the FIFO system, only a push down operation may be needed, and the read electrode 15 may be arranged at the bottom (as shown). Alternatively, the write track 13 could be at the bottom, and the read electrode 13 at the top.

**Table 3**

| | **RBL** | **WBL** | **WBLB** | **PBL** |
|---|---|---|---|---|
| Write 1 | X | V_{SOT} | 0 | X |
| Write 0 | X | 0 | V_{SOT} | X |
| Push down | X | V_{STT}/2 | V_{STT}/2 | 0 |
| Push up | X | 0 | 0 | V_{STT} |

To carry out read, write (SOT nucleate), and push operations, the magnetic memory device 10 and the controller 16 may make use of control signals, in order to allow the excitation signal flow through the write (e.g. SOT) track 13, the memory pillar 11 and the read electrode 15 (e.g. MTJ).

The controller 16 may particularly be configured to control a plurality of write enable switches, and a plurality of read enable switches, and a plurality of push enable switches of the support circuit wit respective signals, so as to perform a write operation, and/or push operation, and/or read operation. The respective signals may comprise read enable (RE), sense amplifier enable (SAE), write enable (WE), and push enable (PE) to control the switches. The switches may drive excitation signals on a read bitline (RBL), write bitline (WBL), write bitline bar (WBLB), and push bit line (PBL), so as to carry out the desired operation as listed in Table 4, which shows statuses of the enable switches during read, SOT nucleate and STT push operations.

**Table 4**

| Operation | **RE** | **SAE** | **WE** | **PE** |
|---|---|---|---|---|
| Read | 1 | 1 | 0 | 0 |
| SOT nucleate | 0 | 0 | 1 | 0 |
| STT push | 0 | 0 | 0 | 1 |

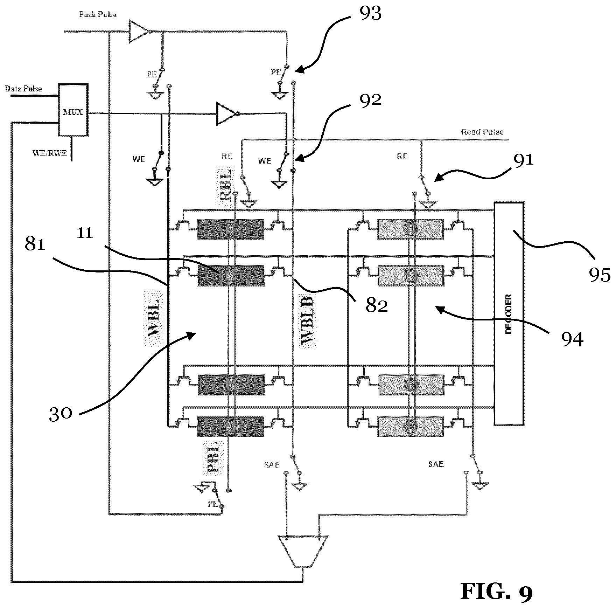

FIG. 9 shows the position of write enable switches 92, read enable switches 91, and push enable switches 93 of the support circuit, and shows the bitline 81, 82 connections in a memory pillar array 30 of the magnetic memory device 10. The exemplary array 30 comprises a single column of memory pillars 11 and a reference column 94 that aids in sensing. This principle is, however, not limited only to two columns. Additional columns could be placed next to the ones shown or in-between. It should generally be understood that this disclosure does not limit itself to this exemplary configuration, and could further extend to all other types of arrays of memory pillars 11.

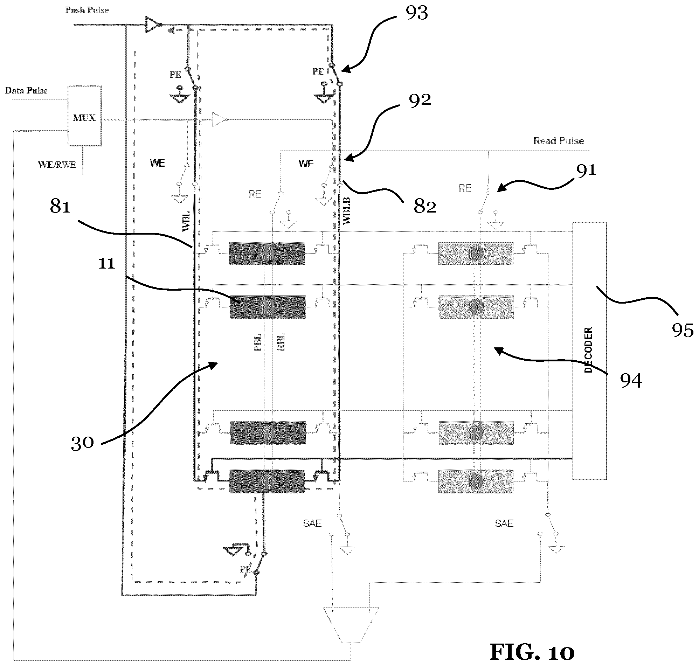

As shown in FIG. 10, when the PE switch 93 is enabled, a push excitation current is split in two and the current travels through WBL 81 and WBLB 82. The decoder 95 ensures only one memory pillar 11 is selected at a time with the aid of selector connected to WBL 81 and WBLB 82. This allows the push current to enter or leave from both the sides of the write track 13 and flow through the memory pillar 11 to cause domain wall motion along the memory pillar 11 based on the direction of the current flow.

Next, various implementations relating a memory re-write in the magnetic memory device 10 will be discussed. Generally, the magnetic memory device 10 may comprise a second support circuit for supporting a rewrite operation of data bits, which have been read from the one or more memory pillars 11.

One way of achieving a non-destructive read operation in the magnetic memory device 10 is by writing back the data to the memory pillar array 30, after sensing or reading it. This operation may include a very well controlled sequence of steps such as read, write (e.g. SOT nucleate) and push (e.g., STT).

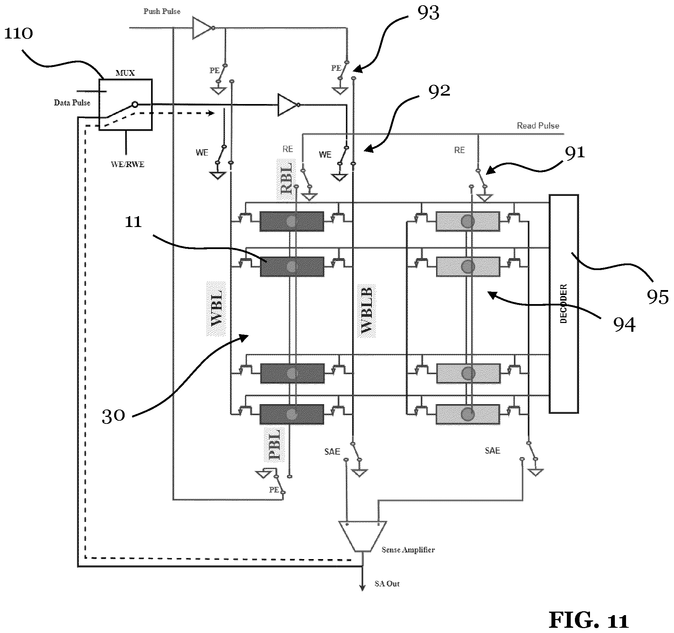

In an implementation, rewriting the sensed data back to a memory pillar 11 can be achieved by using a simple 2 x 1 multiplexer 110 that writes back the data from the sense amplifier to the memory pillar 11, when re-write enable is active (RWE). Else, it would write the user defined data when write enable is active (WE). FIG. 11 shows the addition of the 2 x 1 multiplexer 110 with one input being routed from the output of sense amplifier for writing back.

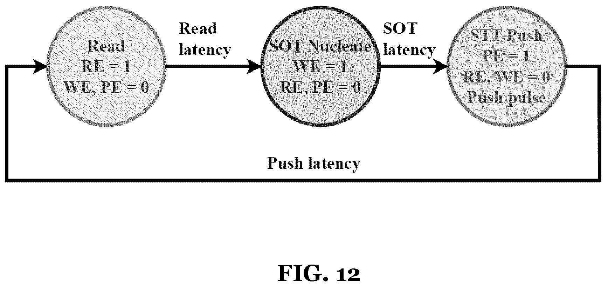

In an implementation, in a controlled sequence of steps, there may be three steps involved in the re-write mechanism. The sequence may start with a read, followed by a write (e.g. SOT nucleate), and then a push (e.g. STT push). Each step takes a finite time interval for execution, referred to as read latency, write latency, and push latency. After the completion of the finite time duration, for example determined using a clock and a counter, the next state is entered. While in a specific state, control signals corresponding to that state are activated along with the excitation signals, as shown in FIG. 12.

Next, implementations relating to configurable input, output, and weight stationaries are described. In these implementations, the magnetic memory device 10 comprises the controller 16 used to control the flow of data in, from, and to the array of memory pillars 11, and may comprise at least one processing element for performing calculations on the high volume of data.

Such a magnetic memory device 10 is intended to be used in applications involving high volume of low precisions computations and/or computations with a large volume of operands, parameters and results (e.g. inputs, weights and outputs), for instance those exploiting imaging filters or artificial neural networks such as convolutional neural networks. In these applications, owing to its high-density property, the magnetic memory device 10 can be used to store the large volumes of input data, and/or weights, and/or output data and to ensure that reading too frequently large amount of data from the buffer is avoided, which would take otherwise too much space and a long time to retrieve. The size of the buffer can thus be reduced to what is strictly necessary and will not be too large. It is then useful for applications where it would be preferable to limit the write-back to the buffer or cache.

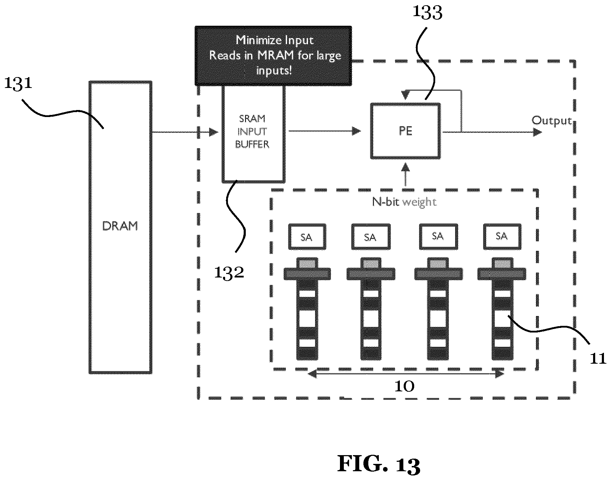

For example, with reference to FIG. 13, a computation circuit is composed of a main dynamic random-access memory (DRAM) 131, a static random-access memory (SRAM) buffer 132, at least a processing element 133, and a magnetic memory device 10 comprising multiple memory pillars 11. The processing element 133 is configured to perform computations on input data, thereby using weights. For example, the processing element 133 may use a neural network for the computations.

The buffer 132 is used as input stationary by fetching the input data from the DRAM 131. This is advantageous for computations accessing multiple times the (large volume of) input data, since access to data stored in SRAM is generally faster than in DRAM. SRAM is however usually expensive, has a large footprint, due to the number of interconnections and involves leakage current at advanced nodes. Therefore, instead of storing also the weights in the buffer 132, the weights are stored inside the magnetic memory device 10. This reduces the SRAM buffer's 132 use to its optimum, and improve energy efficiency and latency, since fewer DRAM fetches are required.

For instance, storing the weights in the magnetic memory device 10 may comprise mapping the weight data access pattern to a plurality of memory pillars 11 of the magnetic memory device 10. For example, the weight data may be organized across 8 memory pillars 11, such that with a parallel push operation performed on the 8 memory pillars 11, the next required INT8 weight data can be obtained. This enables efficient retrieval and fast computation.

The processing element 133 is connected to the buffer 132 and the magnetic memory device 10, so that the output is computed based on the input data retrieved from the buffer 132, the weights retrieved from the magnetic memory device 10, and/or the outcome of the preceding computations.

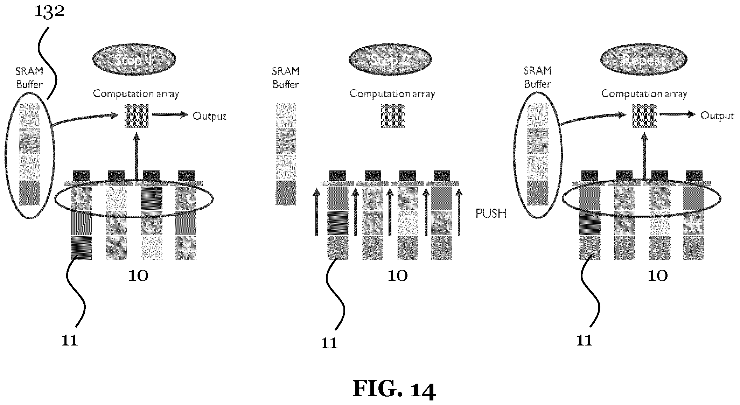

Additionally, processing elements 133 that are used multiple times sequentially, such as when they are used in a systolic array, may be enabled to access the operands stored in the magnetic memory device 10 every clock cycle. The specific 3D architecture of the memory device 10 enhances the operands' reading process by mapping the temporal domain to the vertical axis. Hence, the operands that need to be accessed can simply be pushed to the first memory cell of each memory pillar 11 at each clock cycle (see FIG. 14). Moreover, in such applications where operands of previous steps are not required to be saved, the destructive property of the reading mechanism of the technology of the magnetic memory device 10 does not pose a problem.

Next, implementations relating to an on-chip systolic array are described. A systolic array is highly efficient for large-scale computations, especially those involving repetitive calculations, such as tensor multiplication, convolution operations in deep learning, and other linear algebra computations. It is also useful for tasks in signal processing such as filtering and transforms (e.g., Fast Fourier Transform).

The magnetic memory device 10 may further comprise a systolic array made up of processing elements capable of applying mathematical (more precisely arithmetic and logical) operations on the data, a buffer element holding temporarily data used for computation, accumulating elements collecting and retaining the intermediate results computed by the systolic array and used to compute the final output, and a controller used to control the flow of data in, from and to the systolic array, buffer and accumulating elements.

The systolic array is a specialized hardware architecture used to accelerate computations, particularly in tasks involving matrix multiplication and signal processing. The systolic array may comprise a well-connected grid of processing elements (PEs) that perform operations in a synchronized, pipelined manner. Data may flow through these PEs rhythmically, like a heartbeat (hence the term "systolic"). Each processing element receives data, may perform a computation (such as addition or multiplication), and may pass the result to the next processing element.

Using the memory pillar array of the magnetic memory device 10 in a FIFO configuration along the periphery of the systolic array may enable very small data movement (a push operation instead of fetching from further away), which can further increase compactness and power efficiency of the system.

Since, the magnetic memory device 100 has good memory density along with good writing and reading speed, replacing conventional on-chip memory (SRAM) with the magnetic memory device may also result in optimum performance of tensor processing units (TPUs) with decent speed and density in comparison to existent TPUs employing off-chip DRAM and on-chip SRAM.

Next, some further implementations of the controller 16 of the magnetic memory device 10 are described. The controller 16 may orchestrate the flow of data to and from the memory array(s) of the magnetic memory device 10, ensuring efficient access while meeting timing constraints.

The controller 16 may be configured to translate memory request from a CPU into row, column, bit position in a memory pillar 11 of the magnetic memory device 10, thus selecting the appropriate memory location for read and write operations.

The controller 16 may be configured to schedule the read and/or write operations to maximize performance by handling multiple requests concurrently.

The controller 16 may be implemented by different types of memory controllers. There are a wide variety of memory controller designs, which may be selected based on use case and to get the right balance between power, performance, complexity and flexibility. For instance, for high-speed applications with tight timing constraints a Finite State Machine (FSM) based controller may be favored, while an adaptive or machine learning based controller may excel in dynamic, variable workload environments such as mobile devices and AI applications.

One of the simplest ways of implementing the controller 16 may be by using the FSM that efficiently manages control signals, timing and sequencing of operations such as read, write (e.g., SOT nucleate) and (e.g., STT) push for data access and rewriting data to the magnetic memory pillar array of the magnetic memory device 10.

Generally the controller 16 may comprise processing circuitry configured to perform, conduct or initiate various operations of the memory device 10, as described before. The processing circuitry may comprise hardware and/or the processing circuitry may be controlled by software. The hardware may comprise analog circuitry or digital circuitry, or both analog and digital circuitry. The digital circuitry may comprise components such as application-specific integrated circuits (ASICs), field-programmable arrays (FPGAs), digital signal processors (DSPs), or multi-purpose processors. The controller 16 may further comprise memory circuitry, which stores one or more instruction(s) that can be executed by the processing circuitry, in particular under control of the software. For instance, the memory circuitry may comprise a non-transitory storage medium storing executable software code which, when executed by the processing circuitry, causes the various operations of the controller 16 to be performed. In one embodiment, the processing circuitry comprises one or more processors and a non-transitory memory connected to the one or more processors. The non-transitory memory may carry executable program code which, when executed by the one or more processors, causes the controller 16 perform, conduct or initiate the operations or methods described herein.

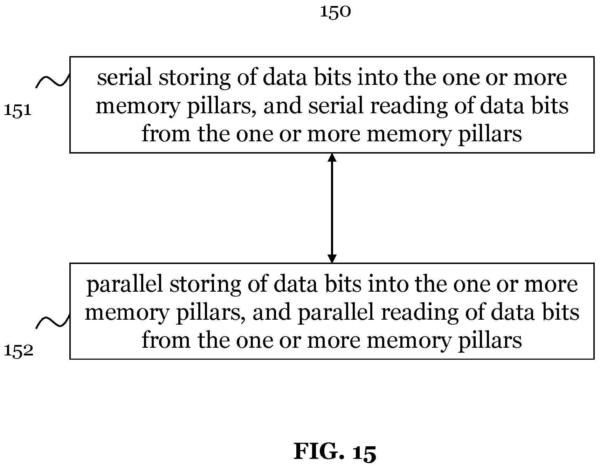

FIG. 15 shows schematically a method 150 for operating the 3D magnetic memory device 10 presented in this disclosure. The method 150 is performed by the controller 16 of the magnetic memory device 10. The method 150 comprises at least one of the following steps:
A step 151 of serial storing of data bits into the one or more memory pillars 11, and serial reading of data bits from the one or more memory pillars 11. For instance, consecutive data bits of data are stored along the memory pillars.

A step 152 of parallel storing of data bits into the one or more memory pillars 11, and parallel reading of data bits from the one or more memory pillars 11. For instance, consecutive data bits of data may be stored into memory pillars 11 arranged in the same row of an array. Thereby, they may be stored row-by row. Within the memory pillars 11, they may be stored in parallel into the same (level) memory cells of the memory pillars, and then the next level, and so on.

In the claims as well as in the description of this disclosure, the word "comprising" does not exclude other elements or steps and the indefinite article "a" or "an" does not exclude a plurality. A single element may fulfill the functions of several entities or items recited in the claims. The mere fact that certain measures are recited in the mutual different dependent claims does not indicate that a combination of these measures cannot be used in an advantageous implementation.

## Claims

1. A three-dimensional, 3D, magnetic memory device (10) comprising:
one or more memory pillars (11), wherein each memory pillar (11) comprises a magnetic channel (12) and a plurality of memory cells (12a), for storing a plurality of magnetic bits, arranged along the magnetic channel (12);
one or more write tracks (13), wherein each write track (13) is associated with at least one of the memory pillars (11), and is controllable to generate a new magnetic bit in each memory pillar (11) associated with said write track (13);
one or more push electrodes (14), wherein each push electrode (14) is associated with one of the memory pillars (11), and is controllable to push the magnetic bits stored in the magnetic channel (12) of said memory pillar (11) along the magnetic channel (12);
one or more read electrodes (15), wherein each read electrode (15) is associated with one of the memory pillars (11), and is controllable to read a magnetic bit from said memory pillar (11);
a controller (16) for controlling a storing of data bits of a data flow as magnetic bits in the one or more memory pillars (11), and for controlling a reading of magnetic bits from the one or more memory pillars (11) as data bits of the data flow;
wherein the controller (16) is configured to control the one or more write tracks (13), push electrodes (14), and read electrodes (15) to perform one of, or more of, or selectively each of the following:
serial storing of data bits into the one or more memory pillars (11);
serial reading of data bits from the one or more memory pillars (11);
parallel storing of data bits into the one or more memory pillars (11);
parallel reading of data bits from the one or more memory pillars (11).

2. The magnetic memory device (10) according to claim 1, wherein
the controller (16) is configured to cause consecutive data bits of the data flow to be stored along a magnetic channel (12) of a memory pillar (11).

3. The magnetic memory device (10) according to claim 1 or 2, wherein
the controller (16) is configured to cause consecutive data bits of the data flow to be stored in multiple memory pillars (11) arranged in a same row of a memory pillar array (30).

4. The magnetic memory device (10) according to claim 3, wherein
the controller (16) is configured to store the data bits row-by-row into multiple rows of the memory pillar array (30).

5. The magnetic memory device (10) according to claim 3 or 4, wherein
the controller (16) is configured to access any row of the memory pillar array (30) multiple times with only a single pre-charge of a wordline connected to the memory pillars (11) of said row.

6. The magnetic memory device (10) according to one of the claims 1 to 5, wherein
the controller (16) is configured to cause consecutive data bits of the data flow to be stored distributed over multiple memory pillars (11) arranged in a tile, wherein the tile comprises two or more rows and/or two or more columns of a memory pillar array (30).

7. The magnetic memory device (10) according to claim 6, wherein
the controller (16) is configured to cause the data bits of the data flow to be stored spread out across all of the memory pillars (11) of said tile.

8. The magnetic memory device (10) according to one of the claims 1 to 7, wherein
the data bits of the data flow are respectively stored in and read from the one or more memory pillars (11) in either a first in first out, FIFO, manner, or in a first in last out, FILO, manner.

9. The magnetic memory device (10) according to one of the claims 1 to 8, further comprising
a first support circuit for supporting a write operation, and/or a push operation, and/or a read operation of data bits of the data flow controlled by the controller (16).

10. The magnetic memory device (10) according to claim 9, wherein
the first support circuit comprises a plurality of bitlines (81, 82) for providing a push current for respectively pushing data bits of the data flow along the one or more memory pillars (11).

11. The magnetic memory device (10) according to claim 9 or 10, wherein
the controller (16) is configured to control a plurality of write enable switches (92), and a plurality of read enable switches (91), and a plurality of push enable switches (93) of the first support circuit, to perform a write operation, and/or push operation, and/or read operation on the data bits of the data flow.

12. The magnetic memory device (10) according to one of the claims 1 to 11, further comprising
a second support circuit for supporting a rewrite operation of data bits of the data flow, which have been read from the one or more memory pillars (11), controlled by the controller (16).

13. The magnetic memory device (10) according to claim 12, wherein
the second support circuit comprises a buffer configured to store data bits extracted during a read operation from the one or more memory pillars (11), and the controller (16) is configured to rewrite the data bits stored in the buffer into the one or more memory pillars (11).

14. The magnetic memory device (10) according to claim 12 or 13, wherein
the controller (16) is configured to control a multiplexer of the second support circuit to selectively perform a write operation to write or a rewrite operation to rewrite data bits into the one or more memory pillars (11).

15. The magnetic memory device (10) according to one of the claims 1 to 14, further comprising
a third support circuit comprising a processor for performing processing operations on data bits of the data flow before storing the data bits into the one or more memory pillars (11) and/or after reading the data bits from the one or more memory pillars (11).

16. The magnetic memory device (10) according to claim 15, wherein
the data flow comprises input data, and/or weights, and/or output data of a trained model, for example, a neural network.

17. The magnetic memory device (10) according to claim 15 or 16, wherein
the third support circuit comprises a feedback loop for feeding back results of the processing operations performed on the data bits to the processor.

18. The magnetic memory device (10) according to one of the claims 15 to 17, wherein
the third support circuit further comprises one or more buffers for temporarily buffering data bits of the data flow used for the processing operations; and
the controller (16) is configured to control the one or more buffers to provide buffered data bits to the processor or buffer data bits received from the processor.

19. The magnetic memory device (10) according to one of the claims 15 to 18, wherein
the third support circuit further comprises one or more accumulators for collecting intermediate processing results of the processing operations performed by the processor; and
the controller (16) is configured to control the one or more accumulators to provide buffered intermediate processing results to the processor or accumulate intermediate processing results received from the processor.

20. A method (150) for operating a three-dimensional, 3D, magnetic memory device (10) according to one of the claims 1 to 19, wherein the method (150) is performed by the controller (16) of the magnetic memory device (10) and comprises at least one of the following:
serial storing (151) of data bits into the one or more memory pillars (11), and serial reading of data bits from the one or more memory pillars (11);
parallel storing (152) of data bits into the one or more memory pillars (11), and parallel reading of data bits from the one or more memory pillars (11).

21. The method (150) according to claim 20, wherein
the serial or parallel storing of the data bits comprises storing of input data, and/or of weights, and/or of output data, of a trained model, for example, of a neural network.

22. The method (150) according to claim 20 or 21, wherein the method comprises
performing one or more processing operations on the data bits before storing the data bits into the one or more memory pillars (11), and/or after reading the data bits from the one or more memory pillars (11); and
optionally, feeding back results of the one or more processing operations performed on the data bits for performing one or more further processing operations.

23. The method (150) according to claim 22, further comprising
temporarily buffering data bits used for the one or more processing operations; and/or
providing buffered data bits for performing further processing operations.

24. The method (150) according to claim 22 or 23, further comprising
collecting intermediate processing results of the one or more processing operations; and/or
providing buffered intermediate processing results for performing one or more further processing operations.

25. A computer program comprising instructions, which, when the computer program is executed of a controller (16) of a magnetic memory device (10), causes the controller (16) to perform the method according to one of the claims 20 to 24.
